(19) **Europäisches Patentamt**

**European Patent Office**

**Office européen des brevets**

(11) **EP 1 107 646 B1**

(12) **EUROPÄISCHE PATENTSCHRIFT**

(45) Veröffentlichungstag und Bekanntmachung des Hinweises auf die Patenterteilung:
**08.02.2006 Patentblatt 2006/06**

(51) Int Cl.:
*H05B 3/62* *(2006.01)*   *C30B 15/14* *(2006.01)*

(21) Anmeldenummer: **00125985.2**

(22) Anmeldetag: **28.11.2000**

(54) **Vorrichtung zum Beheizen von Schmelztiegeln**

Device for heating smelt crucibles

Elément chauffant pour creusets de fusion

(84) Benannte Vertragsstaaten:
**BE DE FR GB IT NL**

(30) Priorität: **09.12.1999 DE 19959416**

(43) Veröffentlichungstag der Anmeldung:
**13.06.2001 Patentblatt 2001/24**

(73) Patentinhaber: **Freiberger Compound Materials GmbH**
**09599 Freiberg (DE)**

(72) Erfinder:
• **Seidl, Albrecht**
**09599 Freiberg (DE)**
• **Eichler, Stefan**
**08122 Dresden (DE)**
• **Köhler, Andreas**
**09599 Freiberg (DE)**

(74) Vertreter: **Prüfer, Lutz H. et al**
**PRÜFER & PARTNER GbR,**
**Patentanwälte,**
**Harthauser Strasse 25d**
**81545 München (DE)**

(56) Entgegenhaltungen:
EP-A- 0 141 649       DE-A- 4 204 777
US-A- 4 467 185       US-A- 4 755 658
US-A- 5 660 752       US-A- 5 766 347

• PATENT ABSTRACTS OF JAPAN vol. 9, no. 324 (C-320) [2047], 19. Dezember 1985 (1985-12-19) & JP 60 155594 A (FURUKAWA DENKI KOGYO KK), 15. August 1985 (1985-08-15)
• PATENT ABSTRACTS OF JAPAN vol. 8, no. 162 (C-235) [1599], 26. Juli 1984 (1984-07-26) & JP 59 064591 A (SUMITOMO DENKI KOGYO K.K), 12. April 1984 (1984-04-12)

**Beschreibung**

Die Erfindung betrifft eine Vorrichtung zum Beheizen von Schmelztiegeln nach dem Oberbegriff des Anspruches 1. Die Vorrichtung ist insbesondere zum Beheizen eines Schmelztiegels bei der Züchtung von Halbleiterkristallen wie Silizium, Germanium und Galliumarsenid verwendbar.

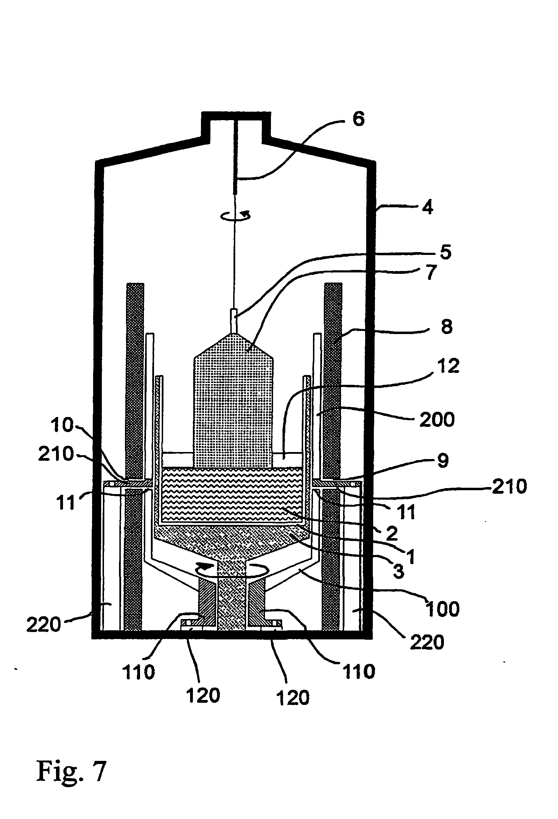

Eine bekannte Vorrichtung zur Züchtung von Halbleiterkristallen nach dem Liquid-Encapsulated-Czochralski (LEC)-Verfahren ist schematisch in Fig. 7 dargestellt. Eine derartige Vorrichtung ist beispielsweise aus Isshiki, M: Recent Development of Bulk Crystal Growth, Research Signpost 1998, S. 63-64 (ISBN: 81-86481-58-3) bekannt. Ein Schmelztiegel 1 zur Aufnahme einer Schmelze 2 aus halbleitendem Material ist auf einem Tiegelhalter 3 innerhalb eines gekühlten Rezipienten 4 angeordnet. Die Halbleiterschmelze 2 ist mit einer Boroxidschmelze 12 abgedeckt, um das Abdampfen flüchtiger Komponenten (z.B. As bei GaAs-Schmelze) zu vermeiden. Um dies zu erreichen, muß der Druck im Rezipienten 4 größer sein als der Dampfdruck der flüchtigen Komponente (z.B. > 2bar im Fall von GaAs). Zum Beheizen des Schmelztiegels 1 ist eine Anordnung von Heizelementen, bestehend aus einem unteren Heizelement 100, welches den Schmelztiegel 1 an seinem Boden und in einem Wandbereich angrenzend an den Boden umgibt und einem oberen Heizelement 200, welches oberhalb des unteren Heizelementes 100 vorgesehen ist und den oberen Bereich der Tiegelwand umgibt. Das untere Heizelement 100 ist über Stromzuführungen 110 mit am Boden des Rezipienten vorgesehenen Elektroden 120 verbunden und das obere Heizelement 200 ist über Stromzuführungen 210 mit ebenfalls am Boden des Rezipienten befindlichen Elektroden 220 verbunden. Ein Kristallkeim 5 ist mit einer durch den Dekkel des Rezipienten 4 durchgeführten oberhalb des Tiegels 1 angeordneten Ziehvorrichtung 6 verbunden. Ferner ist ein wachsender Kristall 7, der aus der Schmelze 2 gezogen wird, über den Kristallkeim 5 mit der Ziehvorrichtung 6 verbunden. Es ist ein Antrieb vorgesehen, über den der Tiegelhalter 3 und der Kristallkeim 5 während des Züchtungsprozesses gegensinnig gedreht werden. Die Anordnung der Heizelemente 100, 200 ist durch ein die Heizelemente ringförmig umgebendes Isolationsrohr 8 aus wärmeisolierendem Material thermisch isoliert. Zwischen dem Isolationsrohr 8 und den Heizelementen 100, 200 ist nur ein geringer Abstand zur Vermeidung von zu starker Gaskonvektion, welche insbesondere bei Halbleitermaterialien mit leicht flüchtiger Komponente wie Galliumarsenid oder Indiumphosphid aufgrund des hohen Drucks im Rezipienten zu großen Temperaturschwankungen führen kann.

Aus US-A-5 766 347 ist ein einteiliges zylinderförmiges Heizelement mit zwei Heizzonen für die Herstellung von einkristallinen Halbleiterkristallen nach dem Czochralski-Verfahren bekannt.

Aus des EP-A-0 141 649 ist eine Vorrichtung zum Beheizen von Schemlztiegeln nach dem Oberbegriff des Anspruchs 1 bekannt. Aus der Zusammenfassung der JP 60 155 594 ist ein zweiteiliges Heizelement bekannt, bei dem zwei Heizelemente miteinander verzahnt sind.

Ein tulpenförmges Heizelement 100 nach dem Oberbegriff des Patentanspruches 1, das als Bodenheizer verwendet wird, ist aus der US 4,533,822 bekannt. Ein hohlzylinderförmiges Heizelement 200 nach dem Oberbegriff des Patentanspruches 1 ist aus der DE 44 23 196 A1 bekannt. Die Kombination des bekannten tulpenförmigen Heizelementes 100 mit dem hohlzylinderförmigen Heizelement 200 in der in Fig. 7 gezeigten vertikalen Anordnung erfordert jedoch eine Unterbrechung der rohrförmigen Wärmeisolation mit dem Isolationsrohr 8 an wenigstens zwei Öffnungen 9, 10 zum Durchführen der Stromzuführungen 210 zu dem oberen Heizelement 200. Durch diese Öffnungen 9, 10 kann kaltes Gas aus dem von dem gekühlten Rezipienten 4 umgebenden Raum einströmen, was sich nachteilig auf das Kristallwachstum auswirkt.

Die vertikale Anordnung zweier wie in Fig. 7 dargestellter Heizelmente ermöglicht eine variable Einstellung des axialen Temperaturgradienten im Innenraum. Ein abrupter thermischer Übergang am Spalt 11 zwischen dem unteren Heizelement 100 und dem oberen Heizelement 200 führt jedoch zu einer Störung des axialen Temperaturverlaufs in diesem Bereich und zu ungünstigen mechanischen Spannungen in dem wachsenden Einkristall, was die Ausbeute an einkristallinem Material verringert.

Aufgabe der Erfindung ist es, ein Heizelement bzw. eine Anordnung von Heizelementen zum Beheizen eines Schmelztiegels, insbesondere für die Züchtung von Halbleiter-Einkristallen zu schaffen, mit dem bzw. mit der Störungen im gewünschten Temperaturverlauf im Bereich von Schmelze und wachsendem Kristall vermieden werden und die Ausbeute verbessert wird.

Die Aufgabe wird gelöst durch eine Vorrichtung zum Beheizen von Schmelztiegeln nach dem Patentanspruch 1. Weiterbildungen der Erfindung sind in den Unteransprüchen angegeben.

Weitere Merkmale und Zweckmäßigkeiten ergeben sich aus der Beschreibung von Ausführungsbeispielen anhand der Figuren.

Von den Figuren zeigen:

Fig. 1    eine erfindungsgemäße Vorrichtung zur Züchtung von Halbleiterkristallen;

Fig. 2a    einen Schnitt durch eine erste Ausführungsform eines erfindungsgemäßen Heizelements;

Fig. 2b    eine Draufsicht auf das Heizelement von Fig. 2a;

Fig. 3a    einen Schnitt durch eine zweite Ausführungsform eines erfindungsgemäßen Heizelements;

Fig. 3b     eine Draufsicht auf das Heizelement von Fig. 3a;

Fig. 4a     einen Schnitt durch die erfindungsgemäße Anordnung von Heizelementen;

Fig. 4b     einen Schnitt gemäß der Linie A-A von Fig. 4a durch die erfindungsgemäße Anordnung von Heizelementen;

Fig. 5     einen Ausschnitt aus einem Schnitt durch eine weitere erfindungsgemäße Anordnung von Heizelementen;

Fig. 6a     eine vergrößerte Ausschnittsdarstellung eines Meanders eines erfindungsgemäßen Heizelements nach einer weiteren Ausführungsform;

Fig. 6b     eine schematische Ansicht eines Ausschnittes einer erfindungsgemäßen Anordnung zweier Heizelemente;

Fig. 6c     eine schematische Darstellung eines Ausschnittes einer weiteren Ausführungsform einer Anordnung von erfindungsgemäßen Heizelementen; und

Fig. 7     eine schematische Darstellung einer bekannten Vorrichtung zum Züchten von Halbleiterkristallen.

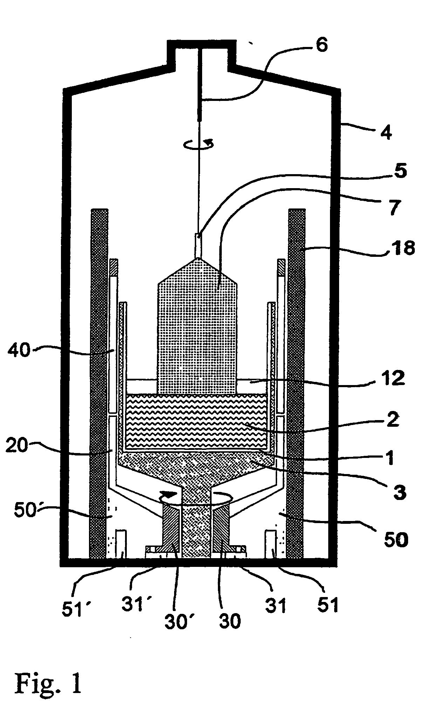

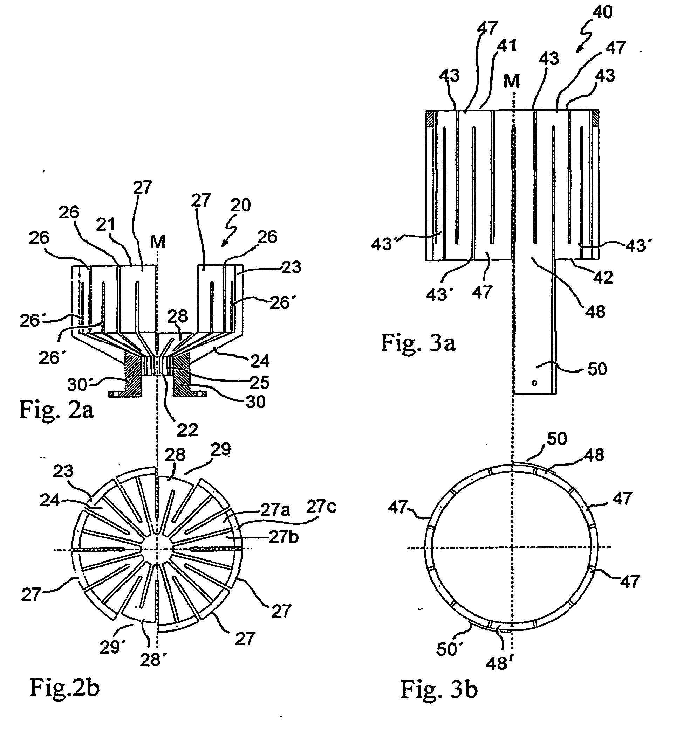

Ein erstes erfindungsgemäßes Heizelement 20 nach einer ersten Ausführungsform ist in den Figuren 2a und 2b und 1 dargestellt. Das Heizelement 20 ist als mantelförmiger Hohlkörper mit einem oberen Rand 21 und einem unteren Rand 22 ausgebildet. Der mantelförmige Hohlkörper weist einen ersten hohlzylinderförmigen Abschnitt 23 auf, dessen Innendurchmesser so bemessen ist, daß der Tiegelhalter 3 mit dem Schmelztiegel 1 darin aufgenommen werden kann. Anschließend an den ersten Abschnitt 23 erstreckt sich ein zweiter Abschnitt 24, in dem sich der Querschnitt des Heizelements konisch verjüngt und der in einen angrenzenden dritten Abschnitt 25 mündet, der einen geringeren Querschnitt als der erste Abschnitt 23 aufweist. Das Heizelement 20 ist somit tulpenförmig ausgebildet. Umfangsseitig erstrecken sich in regelmäßigen Abständen beginnend vom oberen Rand 21 koaxial zur Mittenachse M des Heizelementes Schlitze 26 durch den ersten Abschnitt 23 hindurch, die sich bis in den zweiten Abschnitt 24 erstrecken. Versetzt dazu erstrecken sich beginnend von dem unteren Rand 22 koaxial zur Mittenachse M verlaufende Schlitze 26' durch den dritten Abschnitt 25 und den zweiten Abschnitt 24 bis in den ersten Abschnitt 23 hinein. Die Schlitze 26, 26' sind gleichmäßig beabstandet und teilen den Hohlkörper in einzelne, miteinander verbundene meanderförmige Segmente 27 auf. Jedes meanderförmige Segment 27 ist durch einen Schlitz 26 bzw. 26' in eine linke und eine rechte Meanderhälfte 27a, 27b getrennt, die über eine Meanderkehre 27c miteinander verbunden sind. Im Bereich des unteren Randes 22 sind zwei Stromzuführungen 30, 30' angebracht, über welche das Heizelement 20 mit am Rezipientenboden angeordneten Elektroden 31, 31' verbunden ist.

Zwei diametral gegenüberliegende meanderförmige Segmente 28, 28' sind derart verkürzt, daß sie sich nur von dem dritten Abschnitt 25 bis an die Grenze zwischen dem zweiten Abschnitt 24 und dem ersten Abschnitt 23 erstrecken. Dadurch sind zwei sich gegenüberliegende Aussparungen 29 bzw. 29' oder Lücken von der Breite eines meanderförmigen Segmentes in dem hohlzylinderförmigen Abschnitt 23 gebildet, in denen später beschriebene Stromzuführungen für ein zweites Heizelement angeordnet sind.

Fig. 3a und 3h zeigen zweites Heizelement gemäß einer ersten Ausführungsform. Das Heizelement 40 ist als zylinderförmiger Hohlkörper mit einem oberen Rand 41 und einem unteren Rand 42 ausgebildet. Der Querschnitt des Heizelementes 40 entspricht dem Querschnitt des hohlzylinderförmigen ersten Abschnittes 23 des ersten Heizelements 20. In gleichmäßigen Abständen erstrekken sich alternierend beginnend vom oberen Rand 41 bzw. beginnend vom unteren Rand 42 koaxial verlaufende Schlitze 43 bzw. 43' bis zu einem vordefinierten Abstand zu dem unteren Rand 41 bzw. dem oberen Rand 42. Die Schlitze 43, 43' unterteilen den Hohlkörper in meanderförmige Segmente 47. An zwei umfangsseitig diametral gegenüberliegenden Stellen ist ein meanderförmiges Segment 48, 48' jeweils mit einer Stromzuführung 50, 50' verbunden, deren Breite der Breite des meanderförmigen Segments 48, 48' entspricht und die sich von dem unteren Rand 42 in Verlängerung des meanderförmigen Segments 48, 48' um eine solche Länge erstreckt, daß das Heizelement 40, wenn es in der Kristallzüchtungsanlage angeordnet ist, mit den Stromzuführungen 50, 50' in die Lücken 29, 29' des Heizelementes 20 eingreift und mit den am Rezipientenboden angeordneten Elektroden 51, 51' einer elektrischen Stromquelle verbindbar ist. Bevorzugt ist die Stromzuführung 50, 50' als Verlängerung des meanderförmigen Segments 48, 48' ausgebildet.

Sowohl das Heizelement 20 als auch das Heizelement 40 sind bevorzugt aus Graphit gebildet.

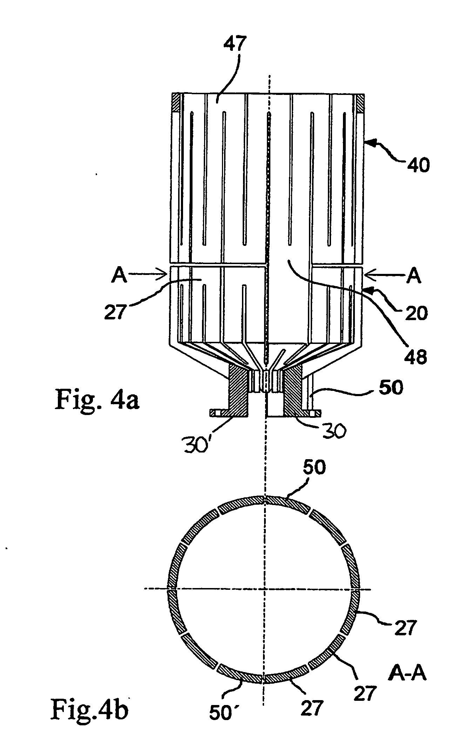

Wie aus den Figuren 4a und 4b ersichtlich ist, besteht die erfindungsgemäße Anordnung von Heizelementen aus einer Kombination des ersten Heizelementes 20 und des zweiten Heizelementes 40. Das Heizelement 40 ist in Betriebszustand oberhalb des Heizelementes 20 derart angeordnet, daß sich die Stromzuführungen 50, 50' des zweiten Heizelementes 40 nahezu exakt in die Ausnehmungen 29, 29' des ersten Heizelementes 20 einfügen. Die Länge der Stromzuführungen des zweiten Heizelementes ist derart gewählt, daß in übereinander angeordnetem Zustand beide Heizelemente mit den jeweils am Boden des Rezipienten vorgesehenen Elektroden 51, 51' einer elektrischen Stromquelle verbindbar sind. Die Stromzuführungen 50, 50' sind hinsichtlich ihrer Breite und Dicke und dem elektrischen Widerstand derart dimensioniert, daß im Betriebszustand ihre Heizleistung etwa der Heizleistung eines benachbarten meanderförmigen Segments 27 des ersten Heizelementes 20 entspricht.

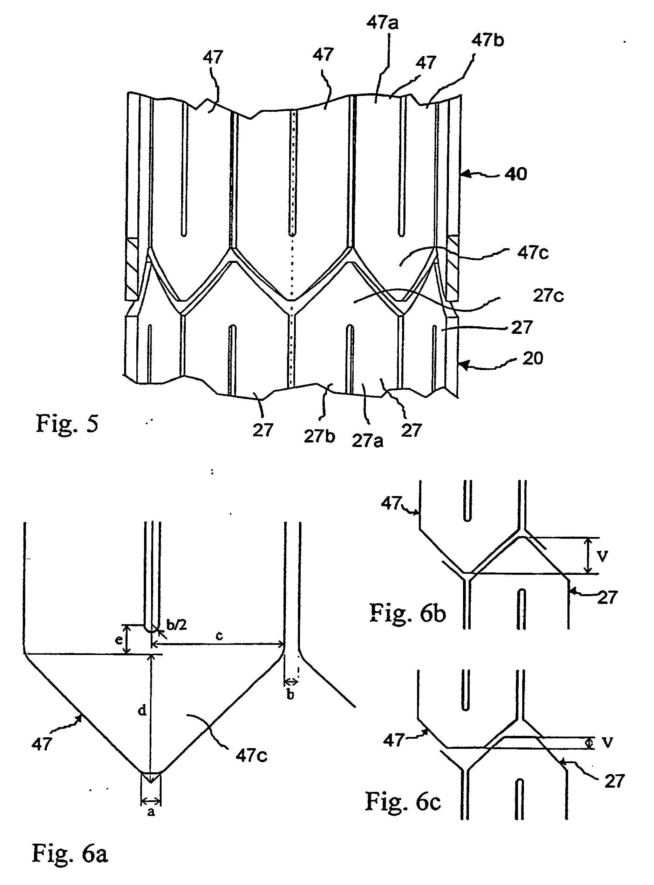

In einer weiteren Ausführungsform der Heizelemente, die in den Figuren 5 und 6a-6c dargestellt ist, ist der obere Rand 21 des ersten, unteren Heizelementes 20 und der untere Rand 42 des oberen, zweiten Heizelementes 40 gezahnt ausgebildet. Jede Meanderkehre 27c bzw. 47c ist dreieckig ausgeformt und die meanderförmigen Segmente 27 des unteren Heizelementes 20 sind gegenüber den meanderförmigen Segmenten 47 des oberen Heizelementes 40 um den Winkel, der einem meanderförmigen Segment entspricht, azimutal gedreht angeordnet, so daß die Heizelemente 20 und 40, wenn sie übereinander angeordnet sind, gegeneinander verzahnt sind bzw. ineinander eingreifen.

Die geometrischen Parameter, welche die Verzahnungstiefe V einer dreieckigen Verzahnung bestimmen, sind in Fig. 6a-6c dargestellt. a kennzeichnet eine Abstumpfung der Dreiecksspitze; b ist der Meanderzwischenraum, d.h. die Breite der zuvor genannten Schlitze 26, 26' bzw. 43, 43', c entspricht der Breite einer Hälfte 27a, 27b, 47a, 47b eines meanderförmigen Segments bzw. der halben Dreiecksbasis; e ist der Abstand zwischen dem Meanderkehrpunkt und der Dreiecksbasis und d ist die Höhe des formgebenden Dreiecks. Für den Fall, daß der kleinste Abstand der Heizer 20, 40 zueinander gleich dem Meanderzwischenraum b ist und die formgebende Geometrie ein Dreieck ist, gilt für die Verzahnungstiefe

$$V = d - \frac{b}{c} \cdot \sqrt{c^2 - d^2} - \frac{a \cdot d}{2c}$$

Bevorzugt ist

$$c = e + d,$$

um eine möglichst homogene Leistungsabgabe im gesamten Heizerbereich zu gewährleisten.

Alle entstehenden Kanten sind abgerundet, um eine Bruchanfälligkeit zu vermindern.

Die erfindungsgemäße Ausbildung der gezahnten Ränder der Heizelemente ist nicht auf die Heizelemente 20 und 40 beschränkt, bei denen die Stromzuführung des oberen Heizelementes 40 in eine Lücke des unteren Heizelementes 20 eingreift. Auch herkömmliche Heizelemente, bei denen eine Stromzuführung für den oberen Heizer durch das Isolationsrohr hindurchgeführt wird, können mit einer derartigen Verzahnung ausgebildet sein. Die Verzahnung kann auch an dem oberen und an dem unteren Rand des jeweiligen Heizelementes vorgesehen sein.

Die erfindungsgemäße Anordnung der Heizelemente 20 und 40 in einer Vorrichtung zur Züchtung eines Halbleiter-Einkristalles nach dem LEC-Verfahren ist in Fig. 1 dargestellt. Die Vorrichtung entspricht der in Zusammenhang mit Fig. 7 beschriebenen Vorrichtung und gleiche Elemente sind mit denselben Bezugszeichen versehen und die Beschreibung derselben wird nicht wiederholt. Im Gegensatz zu der Vorrichtung gemäß Fig. 7 weist die Vorrichtung gemäß Fig. 1 das tulpenförmige erste Heizelement 20 als Bodenheizer auf, dessen Stromzuführungen 30, 30' mit am Boden des Rezipienten befindlichen Elektroden 31, 31' verbunden sind. Oberhalb des ersten Heizelementes 20 ist koaxial dazu ausgerichtet, das zweite Heizelement 40 angeordnet, welches mit seinen Stromzuführungen 50, 50' in die Aussparungen 29, 29' des unteren Heizelementes 20 eingreift. Die Stromzuführungen 50, 50' sind mit am Boden des Rezipienten 4 vorgesehenen Elektrodem 51, 51' verbunden. Dadurch ist es nicht erforderlich, in dem Isolationsrohr 18 Öffnungen zum Zuführen der Stromzuführungen für das zweite Heizelement 40 vorzusehen und das Isolationsrohr 18 ist mit einer geschlossenen Wand ausgebildet. Da von dem zweiten Heizelement 40 keine Teile nach außen hervorstehen, kann das Isolationsrohr 18 mit einem minimalen Abstand zu den Heizelement angeordnet sein, wodurch Wärmeverluste minimiert werden und störende Gaskonvektion bzw. die damit verbundenen Temperaturschwankungen im Bereich des Schmelztiegels 1 nahezu ausgeschlossen sind.

Die Vorrichtung gemäß Fig. 1 weist ferner eine Steuerung zum unabhängigen Steuern der Heizelemente 20, 40 auf. Die Steuerung ist so ausgebildet, daß die Heizleistung des oberen Heizelementes im Bereich der Stromzuführungen 50, 50' der Heizleistung eines benachbarten meanderförmigen Segments 27 des darunterbefindlichen Heizelementes 20 entspricht.

Im Betrieb der Vorrichtung gemäß Fig. 1 wird zunächst über die Heizelemente 20, 40, eine Schmelze 2 des Halbleitermaterials im Tiegel erzeugt. Der Kristallkeim 5 wird in die Schmelze 2 getaucht, wobei an ihm die Bildung des Einkristalles beginnt. Der Kristallkeim 5 wird dabei über die Ziehvorrichtung 6 gedreht, während der Tiegelhalter 3 mit samt dem Tiegel 1 und der darin befindlichen Schmelze 2 gegensinnig zum Kristallkeim gedreht werden. Zu Beginn der Züchtung des Einkristalles wird der in die Schmelze eintauchende Keimkristall möglichst kalt gehalten. um das Ausdampfen von flüchtigen Bestandteilen und die daraus resultierende Zerstörung des Keims zu verhindern, während in einem späteren Züchtungsstadium das bereits gewachsene Kristallstück möglichst warm gehalten wird, um thermische Spannungen zu minimieren. Die dazu erforderlichen Temperaturen werden vor allem durch den oberen Bereich der Heizelementanordnung, d.h. durch das Heizelement 40 eingestellt. Im Bereich der Schmelze werden stabile Temperaturverhältnisse über den unteren Bereich der Heizelementanordnung, d.h. das Heizelement 20 eingestellt. Aus der Schmelze wird dann in bekannter Weise über die Ziehvorrichtung 6 der langsam wachsende Kristall 7 gezogen. Da auch der Bereich der Stromzuführungen 50, 50' des oberen Heizers 40 als heizender Bereich in dem unteren Heizer 20 wirkt, bleibt bei geeigneter Dimensionierung eine gleichförmige azimutale Temperaturverteilung im Bereich des unteren Heizers erhalten. In vertikaler Richtung am Übergang zwischen den beiden Heizelementen 20 und 40 wird durch die gegenseitige Verzahnung der beiden Heizelemente ein kontinuierlicher thermischer Übergang ermöglicht. Durch die ineinandergreifenden meanderförmigen Segmente kommt es azimutal zu einem lokalen Wärmeaustausch, wodurch die axialen Inhomogenitäten des Temperaturfeldes beim herkömmlichen Aufbau gemäß der Erfindung in azimutale Inhomogenitäten überführt werden. Diese werden jedoch durch die Tiegelrotation weitestgehend ausgeglichen.

Die Erfindung hat den Vorteil, daß der Zusammenbau der Heizer einfach und sicher ist, daß Heizer mit geringstmöglichem Maximaldurchmesser und platzsparende seitliche Isolationsrohre verwendet werden können, wodurch eine gute Platzausnutzung gegeben ist und daß minimale Konvektionsräume im Heizerbereich bestehen. Insbesondere bei sehr großen Ofenaufbauten geeignet zur Aufnahme von Schmelztiegeln von 28cm Durchmesser und darüber führt die Erfindung zu einer Kosteneinsparung beim Material hinsichtlich der Graphitteile für die Heizelemente, als auch zu mehr Sicherheit beim Prozeß.

**Patentansprüche**

1. Vorrichtung zum Beheizen von Schmelztiegeln, welche enthält: ein erstes Heizelement, das als mantelförmiger Hohlkörper (20) mit einem oberen Rand (21) und einem unteren Rand (22) ausgebildet ist, wobei der Hohlkörper (20) des ersten Heizelementes einen ersten hohlzylindrischen Abschnitt (23) mit einem ersten Querschnitt und einen daran angrenzenden zweiten Abschnitt (24) mit einem sich verjüngenden Querschnitt aufweist, zum Umgeben eines Bodenbereiches eines Schmelztiegels; und ein zweites Heizelement, welches als zylindrischer Hohlkörper (40) mit einem oberen Rand (41) und einem unteren Rand (42) ausgebildet ist und welches wenigstens eine Stromzuführung (50, 50') aufweist, die sich von dem unteren Rand (42) in Verlängerung der Zylinderwand des Hohlkörpers, (40) erstreckt; **dadurch gekennzeichnet, daß** in dem ersten Abschnitt (23) des ersten Heizelementes wenigstens eine sich von dem oberen Rand (21) bis zum Beginn des zweiten Abschnittes (24) erstreckende Ausnehmung (29, 29') vorgesehen ist, die so bemessen ist, daß darin die Stromzuführung für das angrenzendes zweites Heizelement (40) führbar ist, und die Stromzuführung des zweiten Heizelementes so ausgebildet ist, daß sie die Ausnehmung (29, 29') des ersten Heizelements ausfüllt.

2. Vorrichtung nach Anspruch 1, **dadurch gekennzeichnet, daß** der Hohlkörper (20) des ersten Heizelements sich alternierend von seinem oberen Rand (21) bzw. seinem unteren Rand (22) erstreckende Schlitze (26, 26') aufweist, durch die mäanderförmige Segmente (27) gebildet sind, und wobei die Ausnehmung (29, 29') im ersten Abschnitt (23) durch ein um die Größe der Ausnehmung (29, 29') entsprechend verkürztes mäanderförmiges Segment (28, 28') gebildet ist.

3. Vorrichtung nach Anspruch 1 oder 2, **dadurch gekennzeichnet, daß** der Hohlkörper (20) des ersten Heizelements tulpenförmig ausgebildet ist.

4. Vorrichtung nach einem der Ansprüche 1 bis 3, **dadurch gekennzeichnet, daß** wenigstens zwei Ausnehmungen (29, 29') in dem ersten Heizelement vorgesehen sind.

5. Vorrichtung nach Anspruch 4, **dadurch gekennzeichnet, daß** in dem ersten Heizelement zwei Ausnehmungen (29, 29') vorgesehen sind, die einander gegenüberliegen.

6. Vorrichtung nach einem der Ansprüche 2 bis 5, **dadurch gekennzeichnet, daß** die Mäanderkehren (27c) der mäanderförmigen Segmente (27) des ersten Heizelementes als abgestumpfte Dreiecke ausgebildet sind.

7. Vorrichtung nach einem der Ansprüche 1 bis 6, **dadurch gekennzeichnet, daß** der Hohlkörper (40) des zweiten Heizelementes sich alternierend von seinem oberen Rand (41) bzw. seinem unteren Rand (42) erstreckende Schlitze (43, 43') aufweist, durch die mäanderförmige Segmente (47) gebildet sind, und wobei die Stromzuführung (50, 50') des zweiten Heizelementes als Verlängerung eines mäanderförmigen Segments (48, 48') über den unteren Rand (42) ausgebildet ist.

8. **Vorrichtung** nach einem der Ansprüche 1 bis 7, **dadurch gekennzeichnet, daß** die Stromzuführung (50, 50') des zweiten Heizelementes so ausgebildet ist, daß sie im Betriebszustand eine Heizleistung abgibt, die der Heizleistung der die Ausnehmung (29, 29') umgebenden Abschnitte des ersten Heizelementes (20) entspricht.

9. Vorrichtung nach Anspruch 7 oder 8**, dadurch gekennzeichnet, daß** die Mäanderkehren (47c) der meanderförmigen Segmente (47) des zweiten Heizelementen als abgestumpfte Dreiecke ausgebildet sind.

10. Vorrichtung nach einem der Ansprüche 1 bis 9, **dadurch gekennzeichnet, daß** wenigstens zwei Stromzuführungen (50, 50') für das zweite Heizelement vorgesehen sind.

11. Vorrichtung nach Anspruch 10, **dadurch gekennzeichnet, daß** die zwei Stromzuführungen (50, 50') für das zweite Heizelement einander gegenüberliegend ausgebildet sind.

12. Vorrichtung nach einem der Ansprüche 1 bis 11, **dadurch gekennzeichnet, daß** die Heizelemente (20, 40) jeweils als Hohlkörper ausgebildet sind, der durch alternierend von seinem oberen bzw. unteren Rand ausgehende Schlitze in mäanderförmige Segmente (27, 47) aufgeteilt ist, wobei die einander zugewandten Mäanderkehren (27c, 47c) des oberen bzw. unteren Heizelementes (20, 40) als abgestumpfte Dreiecke ausgebildet sind und wobei die Heizelemente derart zueinander angeordnet sind, daß die Mäanderkehren ineinander eingreifen.

13. Vorrichtung nach einem der Ansprüche 1 bis 12, **dadurch gekennzeichnet, daß die** Heizelemente aus Graphit ausgebildet sind.

14. Verwendung einer Vorrichtung nach einem der Ansprüche 1 bis 13 zum Beheizen eines Schmelztiegels bei der Züchtung von Einkristallen, insbesondere von Galliumarsenideinkristallen.


**Claims**

1. Device for heating crucibles, which contains: a first heating element in the form of a sheath-shaped hollow body (20) with an upper edge (21) and a lower edge (22), whereby the hollow body of the first heating element has a first hollow cylindrical section (23), with a first cross-section and a second section (24) with a tapering cross-section abutting thereon, to encircle a base area of a crucible; and
a second heating element (40) in the form of a cylindrical hollow body with an upper edge (41) and a lower edge (42) and which has at least one power lead (50, 50') which extends from the lower edge (42) in extension of the cylinder wall of the hollow body (40);
**characterised in that** in the first section (23) of the first heating element at least one recess (29, 29') is provided, extending from the upper edge (21) to the start of the second section (24), which recess is dimensioned such that the power lead for the abutting second heating element (40) can be guided therein, and the power lead of the second heating element is designed such that it fills the recess (29, 29') of the first heating element.

2. Device according to claim 1, **characterised in that** the hollow body (20) of the first heating element has slots (26, 26') extending alternately from its upper edge (21) and its lower edge (22) respectively, through which meander-shaped segments (27) are formed, and whereby the recess (29, 29') in the first section (23) is formed by a meander-shaped segment (28, 28') correspondingly curtailed by the size of the recess (29, 29').

3. Device according to claim 1 or 2, **characterised in that** the hollow body (20) of the first heating element is tulip-shaped.

4. Device according to one claims 1 to 3, **characterised in that** at least two recesses (29, 29') are provided in the first heating element.

5. Device according to claim 4, **characterised in that** two opposing recesses (29, 29') are provided in the first heating element.

6. Device according to one claims 2 to 5, **characterised in that** the meander turns (27c) of the meander-shaped segments (27) of the first heating element are in the form of truncated triangles.

7. Device according to one of claims 1 to 6, **characterised in that** the hollow body (40) of the second heating element has slots (43, 43') extending alternately from its upper edge (41) and its lower edge (42) respectively, through which meander-shaped segments (47) are formed, and whereby the power lead (50, 50') of the second heating element is formed as an extension of a meander-shaped segment (48, 48') over the lower edge (42).

8. Device according to one of claims 1 to 7, **characterised in that** the power lead (50, 50') of the second heating element is designed such that when in operation, it emits a calorific output corresponding to the calorific output of the sections of the first heating element (20) surrounding the recesses (29, 29').

9. Device according to claim 7 or 8, **characterised in that** the meander turns (47c) of the meander-shaped segments (47) of the second heating element are in the form of truncated triangles.

10. Device according to one of claims 1 to 9, **character-**

**ised in that** at least two power leads (50, 50') are provided for the second heating element.

11. Device according to claim 10, **characterised in that** the two power leads (50, 50') of the second heating element are placed opposite each other.

12. Device according to one of claims 1 to 11, **characterised in that** the heating elements (20, 40) are each designed as a hollow body, which is divided by slots originating alternately from its upper and lower edge respectively into meander-shaped segments (27, 47), whereby the meander turns (27c, 47c) of the upper and lower heating elements (20, 40) facing towards each other are in the form of truncated triangles, and whereby the heating elements are disposed with respect to each other so that the meander turns engage with each other.

13. Device according to one of claims 1 to 12, **characterised in that** the heating elements are made of graphite.

14. Application of a device according to one of claims 1 to 13 for heating a crucible for the growth of monocrystals, especially of gallium arsenide crystals.


**Revendications**

1. Dispositif pour le chauffage de creusets de fusion, contenant : un premier élément chauffant, réalisé sous la forme de corps creux (20) en forme d'enveloppe, avec un bord supérieur (21) et un bord inférieur (22), le corps creux (20) du premier élément chauffant présentant un premier tronçon (23) cylindrique creux, avec une première section transversale et un deuxième tronçon (24) lui étant limitrophe, avec une section transversale allant en s'effilant, pour entourer une zone de fond d'un creuset de fusion ; et
un deuxième élément chauffant, réalisé sous la forme de corps creux (40) cylindrique, avec un bord supérieur (41) et un bord inférieur (42), et présentant au moins une alimentation électrique (50, 50') s'étendant du bord inférieur (42) dans le prolongement de la paroi cylindrique du corps creux (40), **caractérisé en ce que**, dans le premier tronçon (23) du premier élément chauffant, est prévu au moins un évidement (29, 29'), s'étendant du bord supérieur (21) jusqu'au début du deuxième tronçon (24) et dimensionné de manière que puisse y être guidée l'alimentation électrique pour le deuxième élément chauffant (40) limitrophe, et l'alimentation électrique du deuxième élément chauffant état réalisée de manière qu'elle remplisse l'évidement (29, 29') du premier élément chauffant.

2. Dispositif selon la revendication 1, **caractérisé en ce que** le corps creux (20) du premier élément chauffant présente des fentes (26, 26'), s'étendant en alternance depuis son bord supérieur (21) ou son bord inférieur (22), fentes au moyen desquelles sont formés les segments (27) en forme de méandres, et où l'évidement (29, 29'), dans le premier tronçon (23), est formé par un segment (28, 28') en forme de méandres raccourci de manière à correspondre à la taille de l'évidement (29, 29').

3. Dispositif selon la revendication 1 ou 2, **caractérisé en ce que** le corps creux (20) du premier élément chauffant est réalisé en forme de tulipe.

4. Dispositif selon l'une des revendications 1 à 3, **caractérisé en ce qu'**au moins deux évidements (29, 29') sont prévus dans le premier élément chauffant.

5. Dispositif selon la revendication 4, **caractérisé en ce que** deux évidements (29, 29'), placés à l'opposé l'un de l'autre sont prévus dans le premier élément.

6. Dispositif selon l'une des revendications 2 à 5, **caractérisé en ce que** les rebroussements de méandres (27c) des segments (27) en forme de méandres du premier élément chauffant sont réalisés sous la forme de triangles émoussés.

7. Dispositif selon l'une des revendications 1 à 6, **caractérisé en ce que** le corps creux (40) du deuxième élément chauffant présente des fentes (43, 43') s'étendant en alternance de son bord supérieur (41) ou son bord inférieur (42), fentes au moyen desquelles sont formés des segments (47) en forme de méandres, et l'alimentation électrique (50, 50') du deuxième élément chauffant est réalisé sous forme de prolongement d'un segment (48, 48') en forme de méandres, sur le bord inférieur (42).

8. Dispositif selon l'une des revendications 1 à 7, **caractérisé en ce que** l'alimentation électrique (50, 50') du deuxième élément chauffant est réalisée de manière à fournir, en état de fonctionnement, une puissance de chauffage qui correspond à la puissance de chauffage des tronçons, entourant l'évidement (29, 29'), du premier élément chauffant (20).

9. Dispositif selon la revendication 7 ou 8, **caractérisé en ce que** les rebroussements de méandres (47c) des segments (47) en forme de méandres du deuxième élément chauffant sont réalisés sous la forme de triangles émoussés.

10. Dispositif selon l'une des revendications 1 à 9, **caractérisé en ce qu'**au moins deux alimentations électriques (50, 50') sont prévues pour le deuxième élément chauffant.

**11.** Dispositif selon la revendication 10, **caractérisé en ce que** les deux alimentations électriques (50, 50') pour le deuxième élément chauffant sont réalisées à l'opposé l'une de l'autre.

**12.** Dispositif selon l'une des revendications 1 à 11, **caractérisé en ce que** les éléments chauffants (20, 40) sont chacun réalisés sous la forme de corps creux, subdivisés en segments (27, 47) en forme de méandres, par des fentes partant de façon alternée de son bord supérieur ou inférieur, les rebroussements de méandres (27c, 47c) tournés les uns vers les autres de l'élément chauffant supérieur ou inférieur (20, 40) étant réalisés sous la forme de triangles émoussés, et les éléments chauffants étant disposés les uns par rapport aux autres de manière que les rebroussements de méandres s'engagent les uns dans les autres.

**13.** Dispositif selon l'une des revendications 1 à 12, **caractérisé en ce que** les éléments chauffants sont formés de graphite.

**14.** Utilisation d'un dispositif selon l'une des revendications 1 à 13 pour le chauffage d'un creuset de fusion dans la culture de monocristaux, en particulier de monocristaux d'arséniure de gallium.

Fig. 1

Fig. 2a

Fig.2b

Fig. 3a

Fig. 3b

Fig. 4a

Fig.4b

A-A

Fig. 5

Fig. 6a

Fig. 6b

Fig. 6c

Fig. 7